# EUROPEAN PATENT SPECIFICATION

(11) **EP 0 588 493 B1**
(45) Date of publication and mention of the grant of the patent: **08.11.2000**
(21) Application number: 93306474.3
(22) Date of filing: 17.08.1993
(51) Int. Cl.: H01L 27/148, H04N 3/15

(54) **Charge-coupled devices**
Ladungsgekoppelte Vorrichtungen
Dispositifs de couplage de charge

(30) Priority: 27.08.1992 JP 22881292
(43) Date of publication of application: 23.03.1994
(73) Proprietor: SONY CORPORATION, Tokyo (JP)
(72) Inventor: Hirama, Masahide, c/o Intellectual Prop. Div., Shinagawa-ku, Tokyo 141 (JP)
(74) Representative: Williams, Janice

(56) References cited:
- EP-A- 0 498 662
- EP-A- 0 522 552
- US-A- 4 527 199

## Description

The present invention relates to a CCD (charge-coupled device) device such as a CCD imaging device or the like.

CCD imaging devices, particularly, one-dimensional CCD sensors (linear sensors) are operated in a so-called intermittent mode when in use. In the intermittent mode, reset pulses φ_{RS} are decimated in the ratio of 2 : 1 as compared with the normal mode to thereby mix and read signal charges of two pixels in a floating diffusion region.

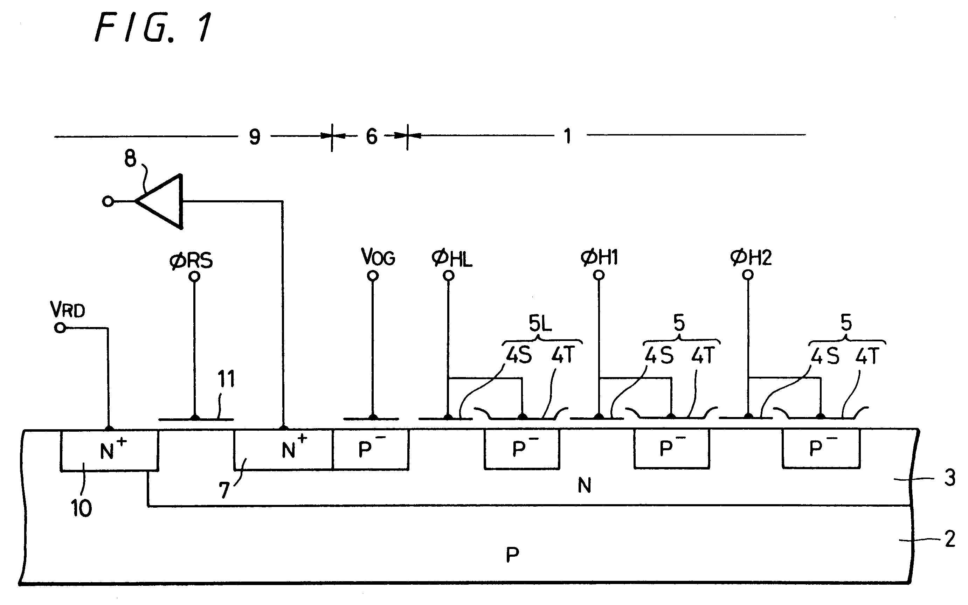

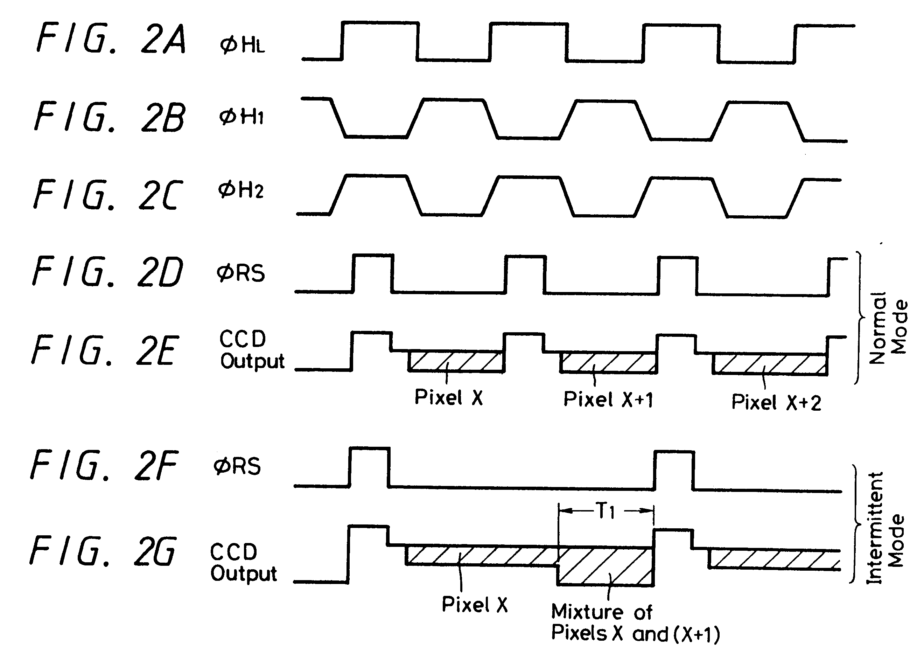

FIG. 1 and FIGS. 2A through 2G of the accompanying drawings show the methods that the one-dimensional CCD sensor is operated in the normal mode and the intermittent mode when in use. FIG. 1 shows structures of a final stage section of a one-dimensional CCD sensor and an output section thereof. As shown in FIG. 1, there is provided a horizontal transfer register 1 which comprises an array of a plurality of transfer sections 5, each of which includes transfer electrodes, i.e., a storage electrode 4S and a transfer electrode 4T formed through an insulating film (not shown) on a major surface of a second conductivity type, i.e., N-type well region 3 formed on a first conductivity type, i.e., P-type semiconductor substrate 2. The horizontal transfer register 1 is adapted to transfer signal charges in response to two-phase clock pulses φ_{H1}, φ_{H2} whose waveforms are illustrated in FIGS. 2B and 2C. In the illustrated example, a transfer section 5L of final stage is provided with an applied terminal which is independent of the terminals of the other transfer sections 5. A clock pulse φ_{HL} whose phase is the same as that of the clock pulse φ_{H2} as shown in FIG. 2A is applied to the aforesaid terminal of the transfer section 5L and the clock pulses φ_{H1}, φ_{H2} are applied to other transfer sections 5.

The transfer section 5L of the final stage is connected to a floating diffusion region 7 through an output gate section 6 to which there is applied a fixed gate voltage (DC voltage) V_{OG}. A signal charge from the horizontal transfer register 1 is transferred to the floating diffusion region 7, in which it is converted in the form of signal charge to voltage and then output through an output amplifier 8. An output section 9 includes a reset gate section 11 formed between the floating diffusion region 7 and a reset drain region 10 to discharge the signal charge transferred to the floating diffusion region 7 to the reset drain region 10 to which a reset pulse φ_{RS} whose waveform is illustrated in FIG. 2D is applied.

In the normal mode, as shown in FIGS. 2D and 2E, the one-dimensional CCD sensor is applied with the reset pulse φ_{RS} in synchronism with a high level period at every period of the clock pulse φ_{HL}, from which CCD outputs (see FIG. 2E) corresponding to signal charge of every pixel (pixel X, pixel x+1, pixel X+2, ...) are read out.

Meanwhile, in the intermittent mode, as shown in FIG. 2F, reset pulses φ_{RS} are applied to this one-dimensional CCD sensor under the condition that they are decimated at every other pulse as compared with the normal mode. Then, signal charges of two pixels (e.g., pixel X and pixel X+1) are mixed together in the floating diffusion region 7 and a CCD output shown in FIG. 2G is thereby read out from this one-dimensional CCD sensor.

In this case, if the speeds of the clock pulses φ_{HL}, φ_{H1}, φ_{H2} are not changed in the intermittent mode and the normal mode, then there arises no problem. On the other hand, from a CCD camera specification standpoint, there is a demand that a read-out speed is increased when a resolution is low (in a so-called intermittent mode). To this end, although the frequencies of the clock pulses φ_{HL}, φ_{H1}, φ_{H2} and the frequency of the reset pulse φ_{RS} must be increased, if the CCD sensor is driven at speed twice as high as the normal speed in actual practice (i.e., speed at which information on a so-called one sheet of paper is read out becomes twice), then a signal period in the intermittent mode, i.e., signal period T₁ in which signal charges of two pixels (e.g., pixel x and pixel X+1) are mixed is reduced to the half of that of the normal mode, causing the circuit system to have a heavy work. There is then the possibility that a signal portion cannot be sampled and held.

European Published Patent Application EP-A-0,498,662 discloses a CCD in which during a low resolution mode adjacent signal charges are mixed in the final output stage by decimating both the final stage transfer pulse and the reset signal such that they are both synchronised with two clock cycles of the transfer pulses for the other stages of the device.

United States Patent US-A-4,527,199 discloses a CCD in which the signal charge for a sensing element can be divided into separate fractions in the final stage before being mixed with some fraction of the signal charge from another sensing element in order to interpolate a signal charge of a higher resolution.

The present invention provides a charge transfer device as defined in claims 1 and 4.

A first embodiment of the invention provides a CCD device in which a floating diffusion region is connected through an output gate section to the final stage of a charge transfer register of a CCD structure to which transfer clock pulses are applied and in which a reset gate section is provided between the floating diffusion region and a reset drain region. When a signal charge is read out in the intermittent mode, a clock pulse φ_{OG} is applied to the output gate section to set a potential of the output gate section at low level so that one signal charge e_{X} is accumulated in the transfer section of the final stage of the charge transfer register. Also, by transfer clocks φ_{HL}, φ_{H1}, φ_{H2}, other signal charge e_{X+1} is transferred to the transfer section of the final stage, whereby the signal charges e_{X} and e_{X+1} are mixed together in the transfer section of the final stage.

Further, the signal charge (e_{X} + e_{X+1}) mixed in the transfer section of the final stage of the charge transfer register is transferred to the floating diffusion region and then output.

A second embodiment of the invention provides a CCD device in which a floating diffusion region is connected through an output gate section to the final stage of a charge transfer register of a CCD structure and in which a reset gate section is provided between the floating diffusion region and a reset drain region. Transfer clock pulses are independently applied to transfer sections of a preceding stage of the charge transfer register and transfer sections of a succeeding stage thereof. When a signal charge is read out in the intermittent mode, transfer clock pulses φ_{H4}, φ_{H3} of period n times (n is an integer) that of transfer clock pulses φ_{H1}, φ_{H2} that are applied to the transfer sections of the preceding stage are applied to the transfer sections of the succeeding stage, whereby signal charges e_{X} and e_{X+1} are mixed together in the transfer section of the succeeding stage.

When a signal charge is read out in the intermittent mode, a fixed voltage V_{OG} is applied to the output gate section.

In the first embodiment of the invention, when a signal charge is read out in the intermittent mode, the clock pulse φ_{OG} is applied to the output gate section, and one signal charge e_{X} and other signal charge e_{X+1,} are mixed together in the transfer section of the final stage of the charge transfer register under the condition that a potential of the output gate section is held at low level. Therefore, a signal period T₂ of an output signal output from the output section is extended as compared with a signal period T₁ required when signal charges are mixed by the floating diffusion region (T₂ > T₁).

In the second embodiment of the invention, transfer clocks are independently applied to transfer sections of preceding stage of the charge transfer register and transfer sections of succeeding stage thereof. When a signal charge is read out in the intermittent mode, transfer clocks φ_{H4}, φ_{H3} of period n times (n is an integer) that of transfer clock pulses φ_{H1}, φ_{H2} that are applied to the transfer sections of preceding stage are applied to the transfer sections of succeeding stage and signal charges e_{X}, and e_{X+1} are mixed together in the transfer section of the succeeding stage. Therefore, a signal period T₃ of an output signal output from the output section is extended as compared with a signal period T₁ used when signal charges are mixed together by the floating diffusion region.

Embodiments of the present invention provide an improved CCD linear sensor in which the shortcomings and disadvantages of the previously proposed devices referred to above can be eliminated.

Further, embodiments of the present invention provide a CCD linear sensor in which a signal period in which a signal charge is read out upon intermittent mode can be extended.

Embodiments of the invention will now be described, by way of example, with reference to the accompanying drawings in which:
FIG. 1 is a diagram showing a structure of an example of a previously proposed CCD device;
FIGS. 2A through 2G are diagrams of waveforms of applied pulses and CCD outputs in the normal mode and the previously proposed intermittent mode, respectively;
FIG. 3 is a diagram showing a structure of a CCD device according to a first embodiment of the present invention;
FIG. 4A through 4F are diagrams of waveforms of applied pulses and CCD output under the condition that the CCD device of FIG. 3 is operated in the intermittent mode, respectively; and
FIGS. 5A through 5H are potential diagrams used to explain operation of the CCD device shown in FIG. 3, respectively;
FIG. 6 is a diagram showing a structure of the CCD device according to a second embodiment of the present invention; and
FIGS. 7A through 7G are diagrams of waveforms of applied pulses and CCD output under the condition that the CCD device of FIG. 6 is operated in the intermittent mode, respectively.

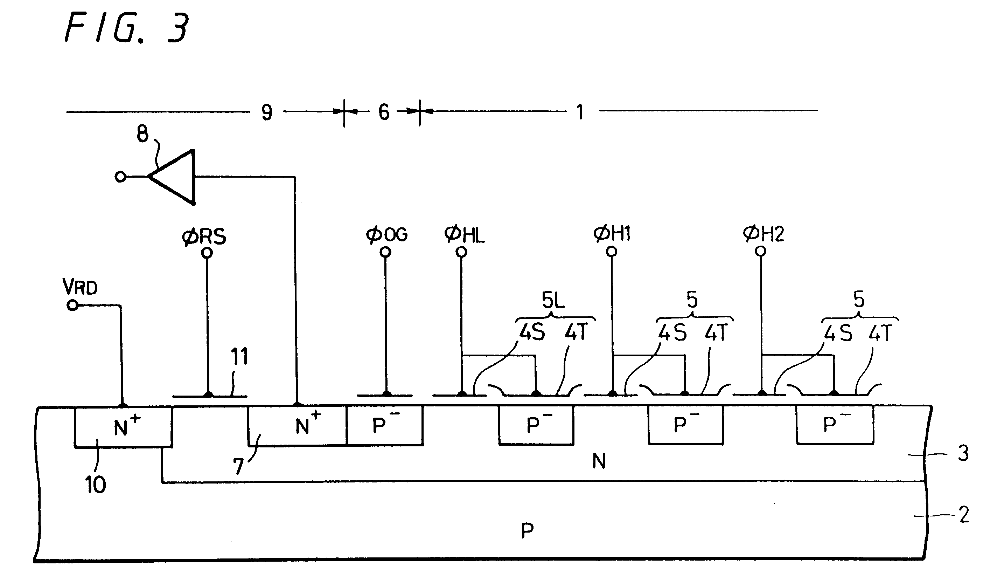

FIG. 3 is a diagram showing a structure of a final stage section and an output section of a horizontal transfer register according to a first embodiment of the present invention which is applied to the CCD device, i.e., one-dimensional CCD sensor. In FIG. 3, like parts identical to those of FIG. 1 are marked with the same references.

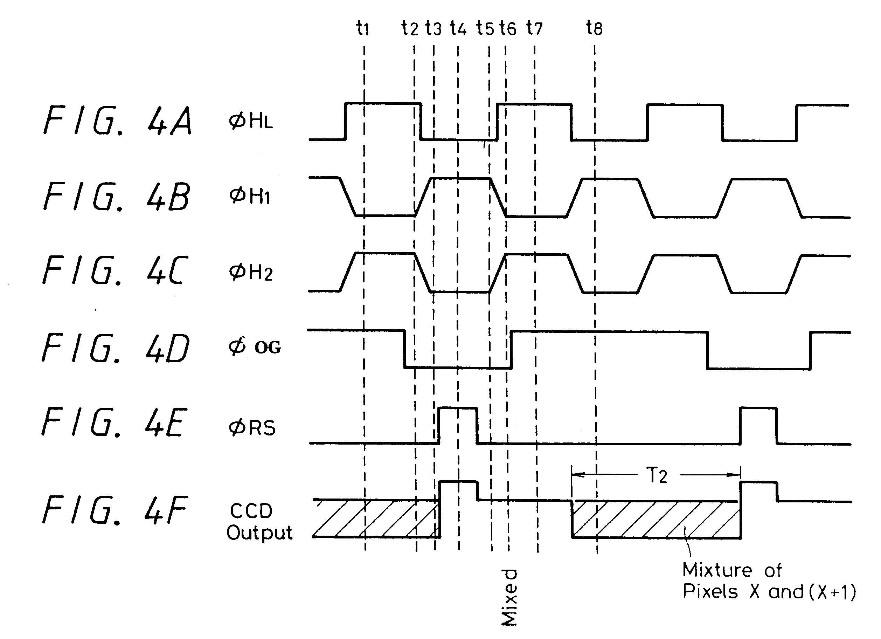

Also in this embodiment, as shown in FIG. 3, the one-dimensional CCD sensor comprises the horizontal transfer register 1 of CCD structure which has an array of a plurality of transfer sections 5, each having the storage electrode 4S and the transfer electrode 4T formed through the insulating film (not shown) on the major surface of the well region 3 formed on the semiconductor substrate 2 to sequentially transfer signal charges in the horizontal direction in response to the two-phase clock pulses φ_{H1}, φ_{H2} (see FIGS. 4B, 4C) similarly to FIG. 1, the output gate section 6 and the floating diffusion region 7 connected to the transfer section 5L of the final stage of the horizontal transfer register 1, the output amplifier 8 connected to the floating diffusion region 7, the reset drain region 10 and the reset gate section 11 which is used to discharge signal charges transferred to the floating diffusion region 7 to the reset drain region 10. The transfer section 5L of the final stage is provided with the independent applied terminal to which the clock pulse φ_{HL} (see FIG. 4A) having the same phase as that of the clock pulse φ_{H2} is applied independently of the other transfer sections 5. The clock pulses φ_{H1}, φ_{H2} are applied to the other transfer sections 5. Furthermore, the predetermined voltage V_{RD} is applied to the reset drain region 10 and the reset pulse φ_{RG} is applied to the reset gate section 11, respectively.

According to this embodiment, signal charges are read out from the one-dimensional CCD sensor in the normal mode similarly to the aforesaid example of the previously proposed device. More specifically, the fixed voltage V_{OG} is applied to the output gate section 6 and the reset pulse φ_{RS} is applied to the reset gate section 11 in synchronism with the high level period of the clock pulse φ_{H1} at every period (see FIG. 2D), whereby the CCD sensor of this embodiment sequentially outputs signals corresponding to signal charges of every pixels (pixel X, pixel X+1, pixel X+2, ...) as shown in FIG. 2E.

When a signal charge is read out in the intermittent mode in which signals of, for example, two pixels are mixed and then read out, the reset pulse φ_{RS} that is applied to the reset gate section 11 is decimated at every other pulse as compared with the normal mode and shifted in phase, i.e., applied in synchronism with the low level period of, for example, the clock pulse φ_{HL}. Further, the output gate section 6 is applied with the clock pulse φ_{OG} synchronized with, for example, the thus decimated reset pulse φ_{RS} instead of the fixed voltage V_{OG} of the normal mode. Then, signal charges (e_{X} and e_{X+1}), (e_{X+2} and e_{X+3}) ... of two pixels (e.g., pixel X and pixel X+1, pixel X+2 and pixel X+3, ...), ..., are mixed together in the transfer section 5L of the final stage of the charge transfer register 1. The signal charge thus mixed is transferred to the floating diffusion region 7, from which it is output through the output amplifier 8.

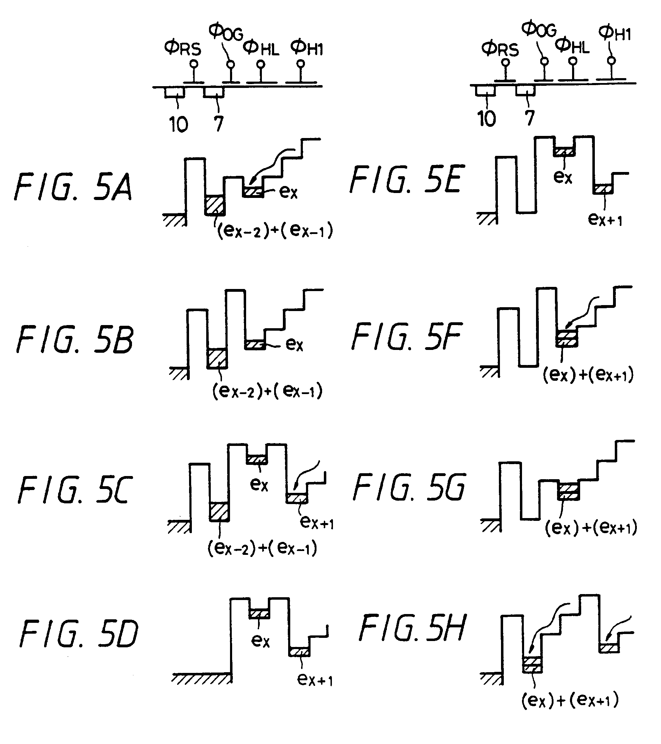

Signal charge transfer operation in the intermittent mode according to this embodiment will be described below with reference to FIGS. 4A through 4F forming waveform diagrams of applied pulses and FIGS. 5A through 5H forming potential diagrams.

At respective timings shown in FIGS. 4A through 4F, the two-phase clock pulses φ_{H1}, φ_{H2} are applied to the transfer sections 5 of the horizontal transfer register 1, the clock pulse φ_{HL} is applied to the transfer section 5L of the final stage, the output gate pulse, i.e., clock pulse φ_{OG} is applied to the output gate section 6 and the reset pulse φ_{RS} is applied to the reset gate section 11, respectively.

At a timing point t₁, potentials of the respective portions are set in the state shown in FIG. 5A so that the signal charge e_{X} of pixel X is transferred from the transfer section 5 applied with the clock pulse φ_{H1} to the transfer section 5L of the final stage to which the clock pulse φ_{HL} is applied. As a CCD output at that time, there is output a signal corresponding to a signal charge (e_{X-2} + e_{X-1}) in which preceding pixels (X-2, X-1) are mixed.

At the next timing point t₂, the clock pulse φ_{OG} that is applied to the output gate section 6 is set to low level before the clock pulse φ_{HL} goes to low level, thereby the respective portions of this one-dimensional CCD sensor being set in the potential states shown in FIG. 5B.

At the next timing point t₃, the clock pulse φ_{HL} that is applied to the transfer section 5L of the final stage goes to low level. Also, since the clock pulse φ_{OG} applied to the output gate section 6 is already held at low level (so-called ground potential), the respective portions are set in the potential states shown in FIG. 5C. Hence, the signal charge e_{X} remains under the storage electrode 4S of the transfer section 5L of the final stage and is not transferred to the floating diffusion region 7. On the other hand, the clock pulse φ_{H1} goes to high level so that the signal charge e_{X+1} of the next pixel X+1 is transferred to the lower portion of the storage electrode 4S of the transfer section 5 that is ahead of the transfer section 5L of the final stage.

At the next timing t₄, the reset pulse φ_{RS} is turned on and the respective portions are set in the potential states shown in FIG. 5D with the result that the signal charge (e_{X-2}, e_{X-1}) in which the pixels X-2, X-1 are mixed together is discharged to the reset drain region 7.

Then, at a timing point t₅ whereat the clock pulse φ_{HL} is at low level, the reset pulse φ_{RS} is turned off, holding the respective portions in the potential states shown in FIG. 5E. Also at this timing point t₅, the clock pulse φ_{OG} that is applied to the output gate section 6 is held at low level so that the signal charge e_{X} of the pixel X remains below the storage electrode 4S of the transfer section 5L of the final stage.

At the next timing point t₆, the clock pulse φ_{HL} goes to high level, the clock pulse φ_{H1} goes to low level and the clock pulse φ_{OG} is yet held at low level so that the respective portions are set in the potential state shown in FIG. 5F. Hence, the signal charge e_{X+1}, of the pixel X+1 is transferred to the lower portion of the storage electrode 4S of the transfer section 5L of the final stage. Then, the two signal charges e_{X} and e_{X+1} of the pixels X and (X+1) are mixed in this transfer section 5L of the final stage.

At the next timing point t₇ whereat the mixed signal charge is not yet transferred from the transfer section 5L of the final stage to the floating diffusion region 7, the clock pulse φ_{OG} is held at high level. At that time, the respective portions are set in the potential states shown in FIG. 5G.

At the next timing point t₈, the clock pulse φ_{HL} goes to low level and therefore the respective portions are set in the potential states shown in FIG. 3H. Consequently, the signal charge (e_{X} + e_{X+1}) mixed by means of the output gate section 6 is transferred to the floating diffusion region 7 so that a signal is output through the output amplifier 8.

According to the first embodiment of the present invention, when signal charges are read out from the CCD sensor in the intermittent mode, the signal charges (e_{X}) and (e_{X+1}) of the two pixels are mixed by the transfer section 5L of the final stage of the horizontal transfer register 1, the signal charges are transferred to the floating diffusion region 7 under the mixed state and then output through the output amplifier 8. Thus, as compared with the case that the signal charges are mixed in the floating diffusion region 7 as in the prior art, the signal period T₂ can be extended (T₂ > T₁). Thus, a work of the circuit system can be reduced as compared with the previous proposals and the read-out speed in the intermittent mode can be increased.

While the case in which the signal charges of two pixels are mixed has been described above, the present invention is not limited thereto and can be similarly applied to the case such that signal charges of three pixels or more are mixed.

Further, while the reset pulse φ_{RS} is turned off at the timing point between the timing points t₄ and t₅ as described above, the present invention is not limited thereto and any trouble will not occur, i.e., the signal period T₂ will not be reduced even when the reset pulse φ_{RS} is turned off before a timing point between timing points t₇ and t₈ at which the clock pulse φ_{HL} goes to low level.

Furthermore, while the impurity profile shown in FIG. 3 is employed as described above, the present invention is not limited thereto and it is sufficient that a potential profile shown in FIGS. 5A through 5H can be realized. Such potential profiles shown in FIGS. 5A through 5H can be realized by varying the voltage applied to the output gate section in response to the pulses φ_{OG}, φ_{HL}, φ_{H1}, φ_{H2} or the like.

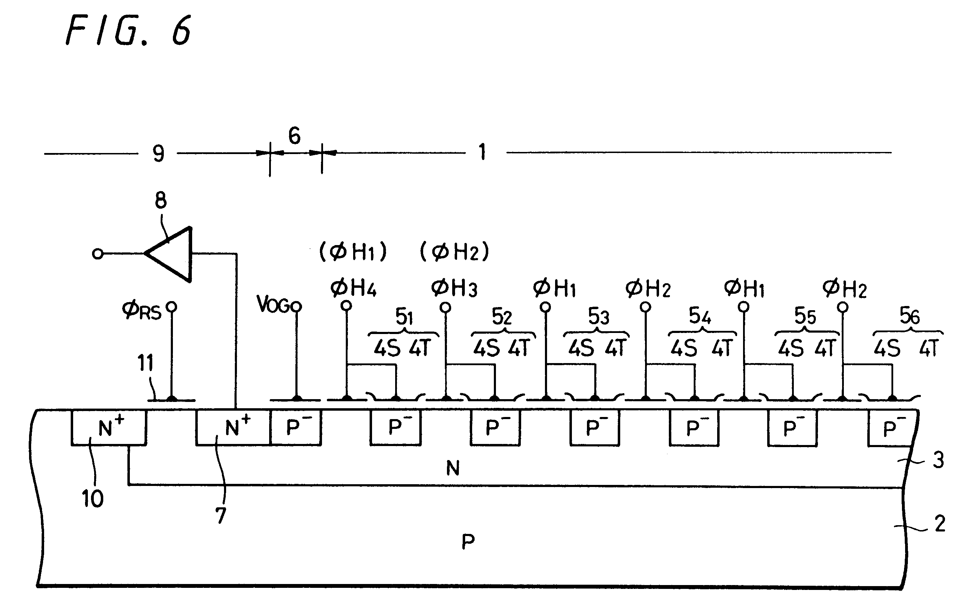

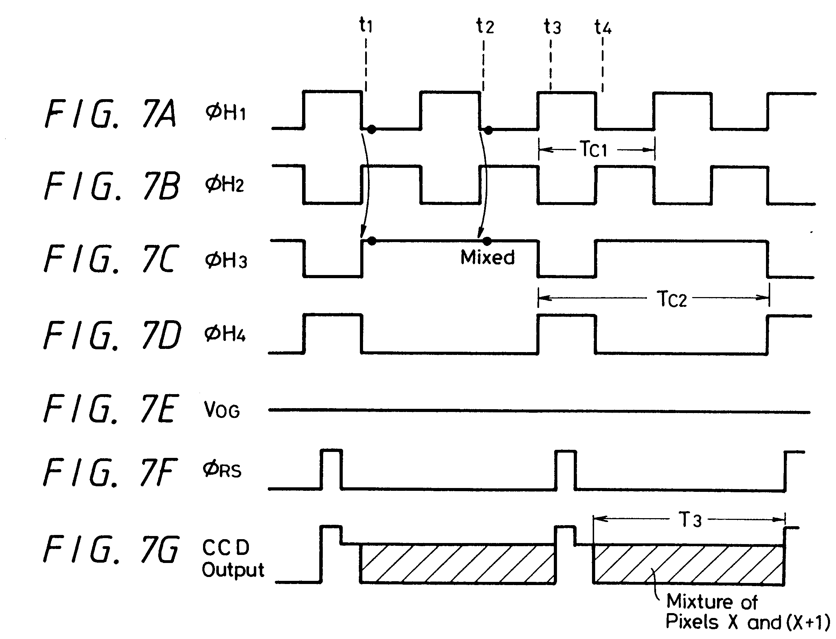

FIG. 6 and FIGS. 7A through 7G are diagrams used to explain a second embodiment of the present invention. In this embodiment, signal charges are mixed together by the transfer section 5 of so-called succeeding stage in addition to the transfer section 5L of the final stage.

FIG. 6 is a diagram showing a structure of the second embodiment of the CCD sensor according to the present invention. In this embodiment, particularly, in the horizontal transfer register 1 that is driven by the two-phase clock pulses φ_{H1}, φ_{H2}, there are independently provided terminals from which clock pulses are applied to the transfer sections of the succeeding stages including the final stage, i.e., transfer sections 5₁, 5₂ and terminals from which clock pulses are applied to transfer sections 5₃, 5₄, 5₅, 5₆, ..., of preceding stage. The rest of structure of the CCD sensor shown in FIG. 6 is similar to that of the CCD sensor shown in FIG. 3. Therefore, identical elements and parts are marked with the same references and need not be described in detail.

In this embodiment, when the CCD sensor is driven in the normal mode in use, the two-phase clock pulses φ_{H1}, φ_{H2} are supplied to all transfer sections (5₁ to 5₆, ...,), whereby signal charges are read out in the normal mode similarly as described before.

When signal charges of, for example, two pixels are mixed and then read out in the intermittent mode, the transfer sections 5₁ and 5₂ of the succeeding stage of the horizontal transfer register 1 are applied with clock pulses φ_{H3}, φ_{H4} (see FIGS. 7C, 7D) whose periods are T_{C2} (> T_{C1}) that is twice the period T_{C1} of the clock pulses φ_{H1}, φ_{H2} (see FIGS. 7A, 7B) that are applied to the transfer sections 5₃, 5₄, 5₅, 5₆, ... of preceding stage. The output gate section 6 is applied with the fixed voltage V_{OG} (see FIG. 7E).

According to the aforesaid structure, as shown in the waveform diagrams forming FIGS. 7A through 7G, at a timing point t₁, the clock pulse φ_{H1} goes to low level and the clock pulse φ_{H3} goes to high level, whereby the signal charge of the pixel X in the transfer section 5₃ is transferred to the storage electrode 4S of the transfer section 5₂.

At the next timing point t₂, the clock pulse φ_{H1} is held at low level and the clock pulse φ_{H3} is still held at high level so that the signal charge e_{X+1} of pixel X+1 in the transfer section 5₃ is transferred to the lower portion of the storage electrode 4S of the transfer section 5₂. Then, the two signal charges e_{X} and e_{X+1} of the pixels X and X+1 are mixed together by the transfer section 5₂.

At the next timing point t₃, the clock-pulse φ_{H3} goes to low level and the clock pulse φ_{H4} goes to high level so that the mixed signal charge (e_{X} + e_{X+1}) is transferred to the transfer section 5₁ of the final stage. Further, at the next timing point t₄, the signal charge thus transferred is transferred to the floating diffusion region 7 and then output from the output amplifier 8.

In accordance with the aforesaid structure, since the signal charges of two pixels are mixed together by the transfer section 5₂ of the succeeding stage of the horizontal transfer register 1 and then transferred to the floating diffusion region 7 under the mixed condition, a signal period T₃ can be extended as compared with the case of the previous proposals (T₃ > T₁).

Furthermore, while the signal charges of two pixels are mixed and then read out when the CCD sensor is driven in the intermittent mode as described above, the present invention is not limited thereto and a variant is also possible. That is to say, if the clock pulses φ_{H3}, φ_{H4} are set to clock pulses whose periods are n times (n is an integer) the periods of the clock pulses φ_{H1}, φ_{H2}, then the present invention can be applied to the case that signal charges of three pixels or more are mixed together.

In embodiments of the present invention, when the signal charge is read out in the intermittent mode, if signal charges are mixed in the transfer sections of the charge transfer register, then the signal period of the output signal can be extended as compared with the previous proposals. Therefore, the work of the circuit system can be reduced and a read-out speed in the internittent mode can be increased.

Having described preferred embodiments of the invention with reference to the accompanying drawings, it is to be understood that the invention is not limited to those precise embodiments and that various changes and modifications could be effected therein by one skilled in the art without departing from the scope of the invention as defined in the appended claims.

## Claims

1. A charge transfer device comprising:
a charge transfer section (5, 5L) to which a plurality of transfer pulses (φ_{H1},φ_{H2},φ_{HL}) may be supplied, said charge transfer section being formed of a plurality of stages, signal charge (ex) being movable between said stages towards a final stage under control of said transfer pulses;
a floating diffusion region (7) formed to receive signal charges from the final stage (5L) of said charge transfer section via an output gate section (6);
a reset drain region (10) formed to receive signal charges from said floating diffusion region via a reset gate section (11); and
driving means for setting the potential (φ_{OG}) of said output gate section to a first level during a normal read-out mode;
characterised in that said driving means is adapted to set the potential of said output gate section to a second level lower than said first level during a first portion of a read-out cycle of an intermittent read-out mode, said intermittent read-out mode being of lower resolution than said normal read-out mode, so as to block signal charges from passing from said final stage to said floating diffusion region and to thereby mix adjacent signal charges (e_{X}, e_{X+1}) transferred through said charge transfer section to said final stage of said charge transfer section and to set the potential of said output gate section to a third level higher than said second level during a second portion of said read-out cycle of said intermittent read-out mode so as to permit signal charges mixed at said final stage to pass from said final stage to said floating diffusion region.

2. The charge transfer device according to claim 1, including means for supplying said plurality of transfer pulses as two-phase transfer pulses.

3. The charge transfer device according to claim 1, wherein said charge transfer section is arrayed in a one-dimensional fashion.

4. A charge transfer device comprising:
a charge transfer section formed of a plurality of stages (5₁ to 5₆), signal charges being movable between said stages towards a final stage (5₁) under control of transfer pulses (φ_{H1},φ_{H2},φ_{H3},φ_{H4}) supplied thereto;
a floating diffusion region (7) formed to receive signal charges from said final stage via an output gate section (6); and
a reset drain region (10) formed to receive signal charges from said floating diffusion region via a reset gate section (11); characterised by
driving means adapted to independently supply during an intermittent read-out mode first transfer pulses (φ_{H4},φ_{H3}) to said final stage (5₁) and a stage (5₂) immediately preceding said final stage and second transfer pulses (φ_{H1},φ_{H2}) to the other stages (5₃,5₄,5₅,5₆) of said charge transfer section, said first transfer pulses having a period n times the period of said second transfer pulses, where n is an integer, whereby n adjacent signal charges may be mixed together in said stage (5₂) immediately preceding said final stage (5₁) before being transferred to said floating diffusion region said final stage.

5. The charge transfer device according to claim 4, including means for supplying said output gate section with a fixed voltage during said intermittent read-out mode.

6. The charge transfer device according to claim 5, including means for supplying said plurality of transfer pulses as two-phase transfer pulses.

## Patentansprüche

1. Ladungsübertragungseinrichtung, aufweisend:
einem Ladungsübertragungsabschnitt (5, 5L), welchem eine Vielzahl von Übertragungsimpulsen (φ_{H1}, φ_{H2}, φ_{HL}) zugeführt werden kann, wobei der Ladungsübertragungsabschnitt aus einer Vielzahl von Stufen gebildet ist und die Signalladung (eₓ) unter Steuerung der Übertragungsimpulse zwischen diesen Stufen in Richtung auf eine Endstufe hin verschiebbar ist;
einem erdungsfreien Diffusionsbereich (7), welcher ausgebildet ist, um die Signalladungen von der Endstufe (5L) des Ladungsübertragungsabschnitts über einen Ausgabegate-Abschnitt (6) zu empfangen;
einem Rücksetzdrain-Bereich (10), welcher ausgebildet ist, um die Signalladungen des erdungsfreien Diffusionsbereichs über einen Rücksetzgate-Abschnitt (11) zu empfangen; und
Steuermitteln zum Einstellen des Potentials (φ_{OG}) des Ausgabegate-Abschnitts auf einen ersten Pegel während eines normalen Auslese-Modus;
dadurch gekennzeichnet,
dass die Steuermittel ausgelegt sind, das Potential des Ausgabegate-Abschnitts auf einen zweiten Pegel, der niedriger als der erste Pegel ist, während eines ersten Teils eines Auslese-Zyklus eines intermittierenden Auslese-Modus einzustellen, wobei der intermittierende Auslese-Modus eine geringere Auflösung als der normale Auslese-Modus aufweist, um zu verhindern, dass Signalladungen von der Endstufe zu dem erdungsfreien Diffusionsbereich passieren und um dadurch benachbarte Signalladungen (eₓ, eₓ₊₁) zu mischen, welche durch den Ladungsübertragungsabschnitt hindurch zu der Endstufe des Ladungsübertragungsabschnitts hin übertragen worden sind, und um das Potential des Ausgabegate-Abschnitts auf einen dritten Pegel einzustellen, welcher höher als der zweite Pegel während eines zweiten Teils des Auslese-Zyklus des intermittierenden Auslese-Modus ist, um zu ermöglichen, dass die in der Endstufe gemischten Signalladungen von der Endstufe zu dem erdungsfreien Diffusionsbereich passieren.

2. Ladungsübertragungseinrichtung nach Anspruch 1, welche Mittel zur Zuführung der Vielzahl von Übertragungsimpulsen als Zwei-Phasen-Übertragungsimpulse enthält.

3. Ladungsübertragungseinrichtung nach Anspruch 1, bei welcher der Ladungsübertragungsabschnitt eindimensional angeordnet ist.

4. Ladungsübertragungseinrichtung, aufweisend:
einem Ladungsübertragungsabschnitt, welcher aus einer Vielzahl von Stufen (5₁ bis 5₆) gebildet ist, wobei die Signalladungen unter Steuerung der diesen zugeführten Übertragungsimpulse (φ_{H1}, φ_{H2}, φ_{H3}, φ_{H4}) zwischen diesen Stufen in Richtung auf eine Endstufe (5₁) hin verschiebbar sind;
einem erdungsfreien Diffusionsbereich (7), welcher ausgebildet ist, um die Signalladungen von der Endstufe (5L) des Ladungsübertragungsabschnitts über einen Ausgabegate-Abschnitt (6) zu empfangen; und
einem Rücksetzdrain-Bereich (10), welcher ausgebildet ist, um die Signalladungen des erdungsfreien Diffusionsbereichs über einen Rücksetzgate-Abschnitt (11) zu empfangen;
gekennzeichnet durch
Steuermittel, welche ausgelegt sind, während eines intermittierenden Auslese-Modus unabhängig erste Übertragungsimpulse (φ_{H3}, φ_{H4}) der Endstufe (5₁) und einer Stufe (5₂), welche der Endstufe unmittelbar vorausgeht, und zweite Übertragungsimpulse (φ_{H1}, φ_{H2}) den anderen Stufen (5₃, 5₄, 5₅, 5₆) des Ladungsübertragungsabschnitts zuzuführen, wobei die ersten Übertragungsimpulse eine Periode aufweisen, welche das n-Fache der Periode der zweiten Übertragungsimpulse beträgt, wobei n eine ganze Zahl ist, wodurch n benachbarte Signalladungen in der der Endstufe (5₁) unmittelbar vorausgehenden Stufe (5₂) miteinander gemischt werden können, bevor sie von der Endstufe zu dem erdungsfreien Diffusionsbereich übertragen werden.

5. Ladungsübertragungseinrichtung nach Anspruch 4, welche Mittel zur Zuführung einer festgelegten Spannung während des intermittierenden Auslese-Modus an den Ausgabegate-Abschnitt enthält.

6. Ladungsübertragungseinrichtung nach Anspruch 5, welche Mittel zur Zuführung der Vielzahl von Übertragungsimpulsen als Zwei-Phasen-Übertragungsimpulse enthält.

## Revendications

1. Dispositif de transfert de charge comprenant :
une section de transfert de charge (5, 5L) à laquelle une pluralité d'impulsions de transfert (φ_{H1}, φ_{H2}, φ_{HL}) peuvent être appliquées, ladite section de transfert de charge étant formée d'une pluralité d'étages, une charge de signal (eₓ) étant mobile entre lesdits étages vers un étage final sous la commande desdites impulsions de transfert ;
une zone de diffusion flottante (7) formée pour recevoir des charges de signal à partir de l'étage final (5L) de ladite section de transfert de charge via une section de grille de sortie (6) ;
une zone de drain de réinitialisation (10) formée pour recevoir des charges de signal à partir de ladite zone de diffusion flottante via une section de grille de réinitialisation (11) ; et
un moyen de commande pour réinitialiser le potentiel (φ_{OG}) de ladite section de grille de sortie à un premier niveau pendant un mode d'extraction normal ;
caractérisé en ce que ledit moyen de commande est adapté pour mettre le potentiel de ladite section de grille de sortie à un second niveau inférieur à celui dudit premier niveau pendant une première partie d'un cycle d'extraction d'un mode d'extraction intermittent, ledit mode d'extraction intermittent étant d'une résolution inférieure à celle dudit mode d'extraction normal, afin de bloquer le passage des charges de signal dudit étage final à ladite zone de diffusion flottante et pour y mélanger des charges de signal adjacentes (eₓ, eₓ₊₁) transférées via ladite section de transfert de charge audit étage final de ladite section de transfert de charge et pour régler le potentiel de ladite section de grille de sortie à un troisième niveau plus élevé que ledit second niveau pendant une seconde partie dudit cycle d'extraction dudit mode d'extraction intermittent afin de permettre aux charges de signal mélangées sur ledit étage final de passer dudit étage final à ladite zone de diffusion flottante.

2. Dispositif de transfert de charge selon la revendication 1, comprenant un moyen pour fournir ladite pluralité d'impulsions de transfert comme des impulsions de transfert à deux phases.

3. Dispositif de transfert de charge selon la revendication 1, dans lequel ladite section de transfert de charge est disposée en réseau d'une manière unidimensionnelle.

4. Dispositif de transfert de charge comprenant :
une section de transfert de charge formée d'une pluralité d'étages (5₁ à 5₆), des charges de signal étant mobiles entre lesdits étages vers un étage final (5₁) sous la commande des impulsions de transfert (φ_{H1}, φ_{H2}, φ_{H3}, φ_{H4}) fournies à celui-ci ;
une zone de diffusion flottante (7) formée pour recevoir des charges de signal à partir dudit étage final via une section de grille de sortie (6) ; et
une zone de drain de réinitialisation (10) formée pour recevoir des charges de signal à partir de ladite zone de diffusion flottante via une section de grille de réinitialisation (11) ; caractérisé par
un moyen de commande adapté pour fournir de façon indépendante pendant un mode d'extraction intermittent des premières impulsions de transfert (φ_{H4}, φ_{H3}) audit étage final (5₁) et un étage (5₂) précédant immédiatement ledit étage final et des secondes impulsions de transfert (φ_{H1}, φ_{H2}) aux autres étages (5₃, 5₄, 5₅, 5₆) de ladite section de transfert de charge, lesdites premières impulsions de transfert ayant une période de n fois la période desdites secondes impulsions de transfert, où n est un entier, de sorte que n charges de signal adjacentes peuvent être mélangées ensemble dans ledit étage (5₂) précédant immédiatement ledit étage final (5₁) avant d'être transférées sur ladite zone de diffusion flottante précédent ledit étage final.

5. Dispositif de transfert de charge selon la revendication 4, comprenant un moyen pour recevoir sur ladite section de grille de sortie une tension fixe pendant ledit mode d'extraction intermittent.

6. Dispositif de transfert de charge selon la revendication 5, dans lequel un moyen pour recevoir ladite pluralité d'impulsions de transfert comme des impulsions de transfert à deux phases.
